# EUROPÄISCHE PATENTSCHRIFT

(11) **EP 1 480 507 B1**
(45) Veröffentlichungstag und Bekanntmachung des Hinweises auf die Patenterteilung: **19.07.2006**
(21) Anmeldenummer: 03101438.4
(22) Anmeldetag: 21.05.2003
(51) Int. Cl.: H05K 13/04

(54) **Halbleiter-Montageeinrichtung**
Semiconductor mounting apparatus
Dispositif de montage de semiconduteur

(43) Veröffentlichungstag der Anmeldung: 24.11.2004
(73) Patentinhaber: Unaxis International Trading Ltd., 6330 Cham (CH)
(72) Erfinder: Thuerlemann, Silvan, 6314, Unteraegeri (CH)
(74) Vertreter: Falk, Urs

(56) Entgegenhaltungen:
- WO-A-00/51408
- DE-A- 10 055 185
- FR-A- 2 457 057
- US-A- 5 210 933
- US-A- 5 313 401

## Beschreibung

Die Erfindung betrifft eine Halbleiter-Montageeinrichtung mit einem Chipgreifer der im Oberbegriff des Anspruchs 1 genannten Art.

Eine derartige Halbleiter-Montageeinrichtung wird generell als "Pick-and-Place" Einrichtung bezeichnet und wird als Bestandteil eines "Die Bonder" genannten Montageautomaten bei der Halbleitermontage verwendet. Sie dient dazu, die zahlreichen, gleichartigen Chips eines Wafers, die sich nebeneinander auf einem Träger befinden, nacheinander auf einem Substrat, z.B. einem metallischen Leadframe, zu montieren. Mit jeder Pick-and-Place-Bewegung koordiniert stellt jeweils der Wafertisch, auf dem sich der Chipträger befindet, einen nächsten Chip bereit, und ebenso wird das Substrat verschoben, um am zweiten Ort einen neuen Substratplatz bereitzustellen. Zum Abheben und nachfolgenden Ablegen der Chips ist der Chipgreifer heb- und senkbar, entweder zusammen mit der ganzen Einrichtung oder für sich allein relativ zur Einrichtung.

An Montageeinrichtungen dieser Art werden extrem hohe Anforderungen gestellt. Für die Weiterverarbeitung der montierten Chips müssen diese lagegenau auf dem Substrat positioniert werden, was ein entsprechend genaues Erreichen des zweiten Ortes durch den Chipgreifer verlangt und auch bereits das genaue Anfahren des ersten Ortes für das Abheben der Chips voraussetzt. Anderseits werden auch hohe Geschwindigkeiten bzw. kurze Taktzeiten verlangt, wodurch entsprechend hohe Beschleunigungen und Massenkräfte an den bewegten Teilen auftreten.

Zur Erzeugung der alternierenden Bewegungen des Chipgreifers werden bisher verschiedene Hebelmechanismen angewendet, die teilweise Kulissenführungen enthalten. Derartige Führungen sind wegen der an ihnen auftretenden, erheblichen Querkräfte für einen präzisen Bewegungsablauf nachteilig und müssen entsprechend gewartet werden. Bei einem anderen bekannten Mechanismus sitzt der Chipgreifer am Ende eines hin und her schwenkenden Hebels, d.h. er erfährt entsprechend den Schwenkausschlägen des Hebels eine bogenförmige Bewegung, die jeweils in den Endlagen gestoppt werden muss, wobei eine starke Neigung zu Schwingungen besteht. Ein Nachteil solcher Hebelantriebe liegt darin, dass sie nur einen Transport des Chips um eine feste, vorbestimmte Strecke von einem Ort A zu einem Ort B erlauben. Pick and Place Einrichtungen mit Hebelmechanismen sind beispielsweise aus den Patentschriften EP 877'544, EP 923'111 und WO 97/32460 bekannt.

Bekannt sind auch Pick and Place Einrichtungen, bei denen der Chipgreifer mittels eines Zahnriemens angetrieben wird. Nachteilig ist hier die grosse Ungenauigkeit der Plazierung des Chips auf dem Substrat.

Um die Halbleiterchips schnell und präzise montieren zu können, soll einerseits die Entfernung zwischen dem Entnahmeort und dem Montageort kurz sein und soll andererseits die mechanische Konstruktion einfach sein. Die Pick and Place Einrichtung der EP 923'111 ist zwar eine einfache und robuste Konstruktion, die eine präzise Platzierung der Halbleiterchips auf dem Substrat ermöglicht, hat aber den Nachteil, dass der Platzbedarf laufend grösser wird, da der Durchmesser der Wafer immer grösser wird. Die ebenfalls bekannte Lösung, bei der der Substrattisch und der Wafertisch übereinander angeordnet sind, hat den Nachteil, dass vom Entnahmeort zum Montageort ein grosser Höhenunterschied bewältigt werden muss.

Die aus der WO 97/32460 bekannte Pick and Place Einrichtung, bei der der Wafertisch orthogonal zum Substrattisch angeordnet ist, hat den Nachteil, dass ab und zu auf der Folie haftende Halbleiterchips herunterfallen und dass sich die Folie infolge der auf die Halbleiterchips einwirkenden Schwerkraft verzieht, so dass sich die Lage des zu entnehmenden Halbleiterchips ungewollt verändert. Zudem kommt es ab und zu vor, dass die Folie aus der vertikalen Ebene heraushängt. Dabei können sich die Ecken oder Kanten benachbarter Halbleiterchips, die nur durch Sägekanäle getrennt sind, berühren. Solche Berührungen führen im schlimmsten Falle dazu, dass Ecken oder Kanten der Halbleiterchips abbrechen, was in der Fachwelt als "Chipping" bekannt ist.

FR 2457057 beschreibt einen Bestückungsautomaten für die Montage von ICs auf einer Leiterplatte.

Der Erfindung liegt die Aufgabe zugrunde, einen Die Bonder zu entwickeln, bei dem die Entfernung zwischen dem Entnahmeort und dem Montageort der Halbleiterchips kurz ist, ohne dass die obengenannten Nachteile bestehen.

Die genannte Aufgabe wird erfindungsgemäss gelöst durch die Merkmale des Anspruchs 1.

Bei der Montage von Halbleiterchips auf ein Substrat wird das Substrat von einer Transportvorrichtung taktweise einer Dispensstation, wo Klebstoff aufgetragen wird, und dann einer Bondstation zugeführt, wo der nächste Halbleiterchip plaziert wird. Die Halbleiterchips haften auf einer auf einen Rahmen aufgespannten Folie und werden auf einem sogenannten Wafertisch bereitgestellt, dort einer nach dem andern von einer als Pick and Place bekannten Einrichtung aufgenommen, transportiert und auf dem Substrat abgesetzt, das auf einer Auflagefläche eines Substrattisches aufliegt. Die Pick and Place Einrichtung umfasst einen Bondkopf mit einem Chipgreifer zur Aufnahme des Halbleiterchips.

Erfindungsgemäss ist bei der Halbleiter-Montageeinrichtung der Wafertisch unter einem vorbestimmten Winkel □ schräg zur Auflagefläche des Substrattisches ausgerichtet, wobei der Wafertisch teilweise unter dem Substrattisch Platz findet. Die Pick and Place Einrichtung umfasst einen Schlitten mit einem Schwenkarm, der den Bondkopf trägt. Der Schwenkarm ist zwischen zwei vorbestimmten Drehlagen hin- und her schwenkbar, wobei in der ersten Drehlage eine Längsachse des Schwenkarms mit der Normalen zur Auflagefläche des Substrattisches den Winkel □ einschliesst und wobei in der zweiten Drehlage die Längsachse des Schwenkarms senkrecht zur Auflagefläche des Substrattisches verläuft. Der Winkel ϕ liegt im Bereich von 10° bis 50°, vorzugsweise im Bereich von 20° bis 35°. Diese Konstruktion ergibt einen optimal kurzen Weg und einen verschwindenden oder geringen Höhenunterschied, den der Halbleiterchip überwinden muss.

Nachfolgend werden Ausführungsbeispiele der Erfindung anhand der Zeichnung näher erläutert. Die Figuren sind nicht massstäblich gezeichnet.

Es zeigen:
- Fig. 1: in seitlicher Ansicht ein erstes Ausführungsbeispiel der Bondstation eines Die Bonders, und
- Fig. 2, 3: Details einer erfmdungsgemässen Pick and Place Einrichtung,
- Fig. 4: in seitlicher Ansicht ein zweites Ausführungsbeispiel der Bondstation eines Die Bonders.

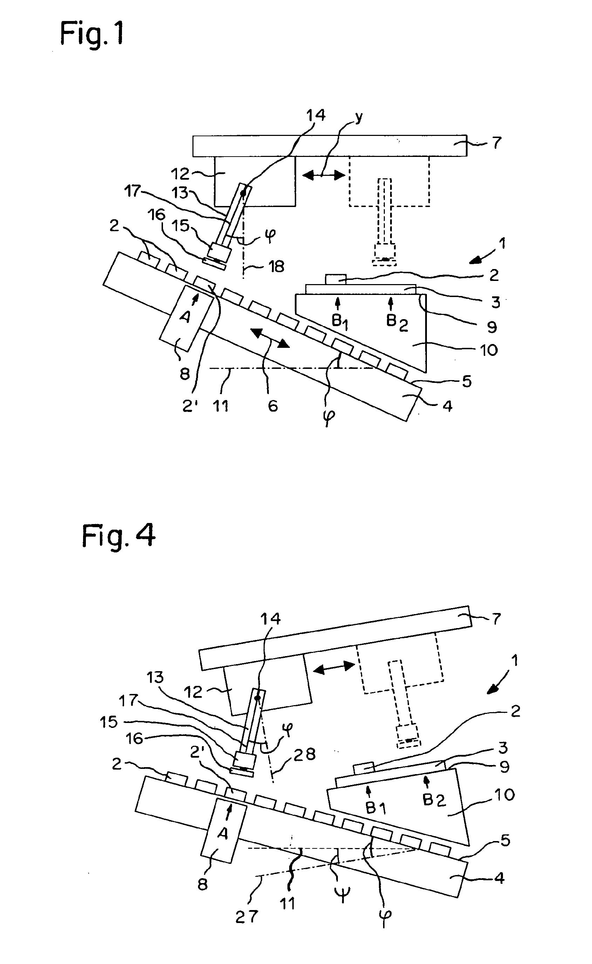

Die Fig. 1 zeigt in seitlicher und schematischer Ansicht einen Die Bonder soweit es für das Verständnis der Erfindung erforderlich ist. Der Die Bonder umfasst eine (nicht dargestellte) Dispensstation, wo Klebstoff auf das Substrat aufgetragen wird, und eine Bondstation 1, wo die Halbleiterchips 2 auf dem Substrat 3 platziert werden. Die Substrate 3 werden von einer (nicht dargestellten) Transportvorrichtung in einer vorbestimmten, als x-Richtung bezeichneten Transportrichtung taktweise zur Dispensstation und zur Bondstation 1 transportiert. Die Transportrichtung verläuft senkrecht zur Zeichenebene der Fig. 1. Die Halbleiterchips 2 werden auf einem Wafertisch 4 bereitgestellt, der einen in die einzelnen Halbleiterchips 2 zersägten Wafer aufnimmt. Die Halbleiterchips 2 sind in Reihen und Kolonnen nebeneinander angeordnet und haften auf einer in einen Rahmen eingespannten Trägerfolie 5. Der Wafertisch 4 ist in zwei orthogonalen Richtungen bewegbar, wobei der Wafertisch 4 im Betrieb jeweils den nächsten zu platzierenden Halbleiterchip an einem festen Ort A bereitstellt. Die eine Bewegungsrichtung des Wafertisches 4 ist durch einen Pfeil 6 dargestellt, die andere Bewegungsrichtung des Wafertisches 4 verläuft senkrecht zur Zeichenebene. Eine Pick and Place Einrichtung 7 dient dazu, den vom Wafertisch 4 am Ort A bereitgestellten Halbleiterchip 2' zu entnehmen und an einem vorgegebenen Ort B₁ oder B₂ oder ... Bₙ auf dem Substrat 3 zu platzieren, wobei der Index n die Anzahl der Substratplätze bezeichnet, die auf dem Substrat 3 nebeneinander angeordnet sind. Im Beispiel ist n=2. Der Wafertisch 4 umfasst einen stationär angeordneten Chip-Auswerfer 8, einen sogenannten Die Ejector, der die Ablösung der Halbleiterchips 2 von der Trägerfolie 5 unterstützt.

In der Bondstation 1 liegt das Substrat 3 auf einer Auflagefläche 9 eines Substrattisches 10 auf. Bei diesem Ausführungsbeispiel ist die Auflagefläche 9 horizontal ausgerichtet. Der Wafertisch 4 ist unter einem vorbestimmten ϕ schräg zur Horizontalen 11 ausgerichtet, so dass die von der Trägerfolie 5 aufgespannte Ebene mit der Horizontalen 11 ebenfalls den ϕ einschliesst. Der Substrattisch 10 ist so konstruiert, dass ein Teil des Wafertisches 4 unterhalb des Substrattisches 10 Platz findet. Der Winkel ϕ liegt bevorzugt im Bereich von 20° bis 35°, er kann aber auch im Bereich von 10° bis 50° liegen.

Die Pick and Place Einrichtung 7 umfasst einen Schlitten 12, der quer zur Transportrichtung der Substrate 3 in einer als y-Richtung bezeichneten Richtung verschiebbar ist. Der Schlitten 12 weist einen Schwenkarm 13 auf, dessen eines Ende um eine parallel zur Transportrichtung der Substrate 3 verlaufende Drehachse 14 drehbar ist. Am gegenüberliegenden Ende des Schwenkarms 13 befindet sich ein Bondkopf 15 mit einem Chipgreifer 16. Der Schwenkarm 13 ist zwischen zwei vorbestimmten Drehlagen hin- und her schwenkbar. In der ersten Drehlage verläuft eine Längsachse 17 des Schwenkarms 13, die die Drehachse 14 durchstösst, unter dem Winkel ϕ zur Vertikalen 18. In der zweiten Drehlage verläuft die Längsachse 17 des Schwenkarms 13 in vertikaler Richtung. Der Chipgreifer 16 ist gegenüber dem Bondkopf 15 entlang der Längsachse 17 auslenkbar. Fakultativ ist der Chipgreifer 16 um die Längsachse 17 drehbar. In der Fig. 1 sind der Schlitten 12, der Schwenkarm 13, der Bondkopf 15 und der Chipgreifer 16 zweimal dargestellt: einmal mit ausgezogenen Linien in der Lage, in der der nächste Halbleiterchip 2' vom Wafertisch 4 entnehmbar ist, und einmal mit gestrichelten Linien in der Lage, in der der aufgenommene Halbleiterchip am Ort B₂ auf dem Substrat platziert wird.

Die Montage des am Ort A bereitgestellten Halbleiterchips erfolgt gemäss dem folgenden Ablauf:
- Der Schwenkarm 13 wird in seine erste Drehlage geschwenkt und der Schlitten 12 fährt eine Position y_{A} an, in der die Längsachse 17 des Schwenkarms 13 mit dem Ort A fluchtet.
- Der bereitgestellte Halbleiterchip wird am Ort A vom Wafertisch 4 entnommen.
- Der Schwenkarm 13 wird in seine zweite Drehlage geschwenkt und der Schlitten 12 fährt eine Position yₖ an, in der die Längsachse 17 des Schwenkarms 13 mit dem Ort Bₖ fluchtet, an dem der Halbleiterchip 2 auf dem Substrat 3 platziert werden soll. Die Drehbewegung des Schwenkarms 13 und die Bewegung des Schlittens 12 sind einander überlagert.
- Der Chipgreifer platziert den aufgenommenen Halbleiterchip 2 am Ort Bₖ auf dem Substrat 3.

Der erfindungsgemässe Die Bonder bietet die folgenden Vorteile:
- Der Transportweg vom Entnahmeort A zum Montageort Bₖ ist kurz.
- Der Transportweg überwindet keinen oder nur einen geringen Höhenunterschied, da sich der Entnahmeort A, bezogen auf den Radius des Schwenkarms 13, nicht oder nur wenig oberhalb oder unterhalb der Auflagefläche 9 des Substrattisches 10 befindet. Der radiale Höhenunterschied ist bestimmt durch den Winkel ϕ, die Länge des Schwenkarms 13 und die Lage des Wafertisches 4. Im Beispiel ist der radiale Höhenunterschied so klein gewählt, dass eine Bewegung des Bondkopfs 15 entlang der Längsachse 17 des Schwenkarms 13 von höchstens ±15 mm, vorzugsweise von weniger als ±10 mm ausreicht, um die Halbleiterchips am Ort A entnehmen zu können und am Ort Bₖ platzieren zu können, selbst bei sogenannten "stagged die" Anwendungen, wo beispielsweise zwei oder drei (verschiedene) Halbleiterchips übereinander montiert werden.
- Die Schwenkbewegung des Schwenkarms 13 erfolgt gleichzeitig während der Bewegung des Schlittens 12 von der Position y_{A} zur Position yₖ. Für die Schwenkbewegung steht somit die maximale Zeit zur Verfügung, die der Schlitten 12 für seine Bewegung benötigt. Dies wirkt sich positiv auf das Schwingungsverhalten bzw. die Ausschwingzeit des Schwenkarms 13 aus.
- Der kurze Weg vom Entnahmeort A zu den Substratplätzen Bₖ ermöglicht eine kompakte Konstruktion der Pick and Place Einrichtung 7, für die deshalb problemlos eine hohe mechanische Steifigkeit erreicht werden kann, was wiederum eine reduzierte Anfälligkeit für Schwingungen bedeutet.

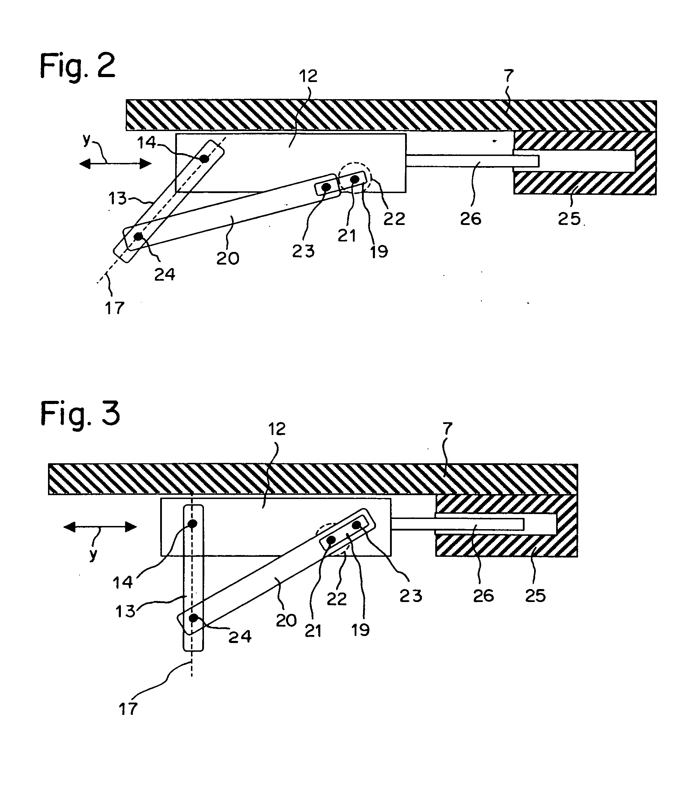

Die Fig. 2 zeigt in seitlicher Ansicht ein Ausführungsbeispiel der Pick and Place Einrichtung 7, bei der die Schwenkbewegung des Schwenkarms 13 mittels eines Hebelmechanismus erfolgt, wobei die erste und die zweite Drehlage des Schwenkarms 13 durch die Strecklage von zwei Hebeln 19 und 20 bestimmt sind. Der erste Hebel 19 dient als Antriebshebel: ein erstes Ende des Hebels 19 ist auf der Welle 21 eines auf dem Schlitten 12 angeordneten Motors 22 befestigt, das andere Ende des ersten Hebels 19 ist mit einem ersten Ende des zweiten Hebels 20 über eine Welle 23 verbunden. Das zweite Ende des zweiten Hebels 20 ist über eine Welle 24 mit dem Schwenkarm 13 verbunden. Der Motor 22 dreht den ersten Hebel 19 zwischen zwei Endlagen hin und her, bei denen sich die beiden Hebel 19 und 20 zueinander in Strecklage befinden. Mit dem Begriff "Strecklage" ist gemeint, dass die drei Wellen 21, 23 und 24 auf einer Geraden liegen. Die Endlagen des ersten Hebels 19 sind vorzugsweise durch zwei Anschlagsflächen am Schlitten 12 definiert. Die Fig. 2 zeigt den Schwenkarm 13 in der ersten Drehlage, in der seine Längsachse 17 mit dem Ort A fluchtet. Die Fig. 3 zeigt den Schwenkarm 13 in der zweiten Drehlage, in der seine Längsachse 17 orthogonal zur Auflagefläche 9 des Substrattisches 10 verläuft.

Die Bewegung des Schlittens 12 in der y-Richtung wird durch einen Motor bewerkstelligt, der vorzugsweise ein herkömmlicher Linearmotor ist. Der Linearmotor weist einen ortsfest angeordneten, mit Magneten versehenen Stator 25 und einen mit dem Schlitten 12 verbundenen Spulenkörper 26 auf. Der Schlitten gleitet in Führungselementen. Die y-Lage des Schlittens 12 wird mittels eines Positionsmess- und Regelsystems ermittelt und geregelt, wobei das Positionsmesssystem vorzugsweise aus einem ortsfest angeordneten Metall- oder Glasmassstab und einem am Schlitten 12 angebrachten Lesekopf besteht.

Für die Entnahme des Halbleiterchips vom Wafertisch 4 und für das Platzieren des aufgenommenen Halbleiterchips auf dem Substrat 3 sind viele verschiedene Prozesse bekannt und auch viele Ausführungsformen von Bondkopf 15 und Chipgreifer 16. Als ausgewähltes Beispiel sei hier das als Overtravel bekannte Verfahren erwähnt, bei dem der Bondkopf 15 soweit abgesenkt wird, dass der Chipgreifer 16 gegenüber dem Bondkopf 15 ausgelenkt wird, wobei sowohl bei der Entnahme des Halbleiterchips als auch beim Platzieren des Halbleiterchips eine vorbestimmte Pick- bzw. Bondkraft erzeugt wird. Aus der europäischen Patentanmeldung EP 1'321'967 ist ein Bondkopf 15 bekannt, bei dem die Auslenkung des Chipgreifers 16 gegenüber dem Bondkopf 15 pneumatisch geregelt wird. Für die Regelung der Auslenkung des Chipgreifers 16 stehen zwei Betriebsarten zur Verfügung. In der ersten Betriebsart wird die Auslenkung des Chipgreifers 9 oder eine davon abgeleitete Grösse geregelt. In der zweiten Betriebsart wird eine Druckdifferenz geregelt, die die vom Chipgreifer 9 aufzubringende Pick- bzw. Bondkraft erzeugt. Die erfindungsgemässe Pick and Place Einrichtung 7 kann für die Zusammenarbeit mit all diesen unterschiedlichen, bekannten Bondköpfen konzipiert werden.

Die Fig. 4 zeigt ein Ausführungsbeispiel, bei dem die Auflagefläche 9 des Substrattisches 10 gegen den Wafertisch 4 hin geneigt ist und mit der Horizontalen 11 einen vorbestimmten ψ einschliesst. (Die Linie 27 verläuft parallel zur Auflagefläche 9 des Substrattisches 10.) Der Wafertisch 4 schliesst mit der Horizontalen 11 somit nur noch den reduzierten Winkel ϕ - ψ ein. Ansonsten ist das Ausführungsbeispiel mit dem ersten Ausführungsbeispiel im wesentlichen identisch und die Bezugszeichen bezeichnen die gleichen Gegenstände wie beim ersten Ausführungsbeispiel. In der ersten Drehlage schliesst der Schwenkarm 13 den Winkel ϕ mit der Normalen 28 zur Auflagefläche 9 des Substrattisches 10 ein. In der zweiten Drehlage verläuft die Längsachse 17 des Schwenkarms 13 senkrecht zur Auflagefläche 9 des Substrattisches 10. Die Pick and Place Einrichtung 7 ist ebenfalls um den Winkel ψ zur Horizontalen 11 geneigt, so dass die Bewegung des Schlittens 12 parallel zur Auflagefläche 9 des Substrattisches 10 verläuft.

## Patentansprüche

1. Halbleiter-Montageeinrichtung, umfassend einen Substrattisch (10) mit einer Auflagefläche (9) für das Substrat (3), eine Transportvorrichtung für den Transport des Substrats (3) zum Substrattisch (10), einen Wafertisch (4) für die Bereitstellung eines Halbleiterchips (2; 2) an einem ersten Ort, und eine Pick und Place Einrichtung (7), die den am ersten Ort bereitgestellten Halbleiterchip (2') entnimmt und auf dem Substrat (3) platziert, **dadurch gekennzeichnet, dass** der Wafertisch (4) unter einem vorbestimmten Winkel ϕ schräg zur Auflagefläche (9) des Substrattisches (10) ausgerichtet ist und teilweise unterhalb des Substrattisches (10) Platz findet, und dass die Pick and Place Einrichtung (7) einen in einer vorbestimmten Richtung (y) beweglichen Schlitten (12) mit einem Schwenkarm (13) umfasst, wobei der Schlitten (12) in eine erste Position bewegbar und der Schwenkarm (13) in eine erste vorbestimmte Drehlage schwenkbar ist, in der eine Längsachse (17) des Schwenkarms 13 mit der Normalen (28) zur Auflagefläche (9) des Substrattisches (10) den Winkel ϕ einschliesst, um den Halbleiterchip (2') aufzunehmen, und wobei der Schlitten (12) in eine andere Position bewegbar und der Schwenkarm (13) in eine zweite vorbestimmte Drehlage schwenkbar ist, in der die Längsachse (17) des Schwenkarms (13) senkrecht zur Auflagefläche (9) des Substrattisches (10) verläuft, um den Halbleiterchip (2') auf dem Substrat (3) zu platzieren.

2. Halbleiter-Montageeinrichtung nach Anspruch 1, **dadurch gekennzeichnet, dass** der Winkel ϕ im Bereich von 10° bis 50° liegt.

3. Halbleiter-Montageeinrichtung nach Anspruch 1, **dadurch gekennzeichnet, dass** der Winkel ϕ im Bereich von 20° bis 35° liegt.

4. Halbleiter-Montageeinrichtung nach einem der Ansprüche 1 bis 3, **dadurch gekennzeichnet, dass** die erste und die zweite Drehlage des Schwenkarms (13) durch zwei Hebel (19, 20) bestimmt sind, die sich in der ersten und der zweiten Drehlage des Schwenkarms (13) zueinander in Strecklage befinden.

## Claims

1. Apparatus for mounting semiconductors, comprising a substrate table (10) with a supporting surface (9) for the substrate (3), a transport device for transporting the substrate (3) to the substrate table (10), a wafer table (4) for presenting a semiconductor chip (2; 2') at a first location, and a pick and place device (7), that picks the semiconductor chip (2) presented at the first location and places the semiconductor chip (2) onto the substrate (3), **characterised in that** the wafer table (4) is aligned diagonally to the supporting surface (9) of the substrate table (10) at a predetermined angle ϕ and part of the wafer table (4) is located under the substrate table (10), and that the pick and place device (7) comprises a shuttle (12) that can be moved in a predetermined direction (y) and that has a swivel arm (13), whereby the shuttle (12) can be moved to a first position and the swivel arm (13) can be swivelled into a first predetermined swivel position, in which a longitudinal axis (17) of the swivel arm (13) embraces the angle ϕ with the perpendicular (28) to the supporting surface (9) of the substrate table (10), for picking the semiconductor chip (2'), and whereby the shuttle (12) can be moved to another position and the swivel arm (13) can be swivelled into a second predetermined swivel position, in which the longitudinal axis (17) of the swivel arm (13) runs orthogonally to the supporting surface (9) of the substrate table (10), for placing the semiconductor chip (2') on the substrate (3).

2. Apparatus for mounting semiconductors according to claim 1 **characterised in that** the angle ϕ lies in the range of 10° to 50°.

3. Apparatus for mounting semiconductors according to claim 1 **characterised in that** the angle ϕ lies in the range of 20° to 35°.

4. Apparatus for mounting semiconductors according to any of claims 1 to 3, **characterised in that** the first and second swivel positions of the swivel arm (13) are determined by means of two levers (19, 20) that are in extended positions with respect to each other in the first and second swivel positions of the swivel arm (13).

## Revendications

1. Dispositif de montage de semi-conducteurs, comprenant une table à substrat (10) présentant une surface de support (9) pour le substrat (3), un dispositif de transport pour le transport du substrat (3) vers la table à substrat (10), une table à plaquettes de silicium (4) pour la mise à disposition d'une puce à semi-conducteurs (2; 2') sur un premier emplacement, et un dispositif de prélèvement et de mise en place (7) qui prend la puce à semi-conducteurs (2') présentée sur le premier emplacement et qui la place sur le substrat (3), **caractérisé en ce que** la table à plaquettes de silicium (4) est orientée à l'oblique par rapport à la surface de support (9) de la table à substrat (10) sous un angle pré-défini ϕ et trouve en partie de la place en dessous de la table à substrat (10), et **en ce que** le dispositif de prélèvement et de mise en place (7) comporte un chariot (12) mobile dans une direction prédéterminée (y) avec un bras pivotant (13), dispositif dans lequel il est possible de déplacer le chariot (12) dans une première position et de pivoter le bras pivotant (13) dans une première position de rotation prédéterminée dans laquelle un axe longitudinal (17) du bras pivotant (13) inclut l'angle ϕ avec la normale (28) par rapport à la surface de support (9) de la table à substrat (10), afin de réceptionner la puce à semi-conducteurs (2'), et dans lequel il est possible de déplacer le chariot (12) dans une autre position et de pivoter le bras pivotant (13) dans une deuxième position de rotation prédéterminée dans laquelle l'axe longitudinal (17) du bras pivotant (13) s'étend perpendiculairement à la surface de support (9) de la table à substrat (10), afin de placer la puce à semi-conducteurs (2') sur le substrat (3).

2. Dispositif de montage de semi-conducteurs selon la revendication 1, **caractérisé en ce que** l'angle ϕ se trouve dans la plage de 10° à 50°.

3. Dispositif de montage de semi-conducteurs selon la revendication 1, **caractérisé en ce que** l'angle ϕ se trouve dans la plage de 20° à 35°.

4. Dispositif de montage de semi-conducteurs selon l'une des revendications 1 à 3, **caractérisé en ce que** la première et la deuxième position de rotation du bras pivotant (13) sont déterminées par deux leviers (19, 20) qui se trouvent en position d'extension l'un par rapport à l'autre, dans la première et dans la deuxième position de rotation du bras pivotant (13).
